# EUROPEAN PATENT APPLICATION

(11) **EP 4 687 213 A1**
(43) Date of publication of application: **04.02.2026**
(21) Application number: 24192219.4
(22) Date of filing: 01.08.2024
(51) Int. Cl.: H01P 5/08, H01P 5/12

(54) **N-WAY RF SPLITTER-COMBINER, AND ARRANGEMENT COMPRISING THE SAME**

(71) Applicant: Rohde & Schwarz GmbH & Co. KG, 81671 München (DE)
(72) Inventor: Schenk, Lothar, 12555 Berlin (DE); Riedel, Christian, 94539 Grafling (DE); Laurisch, Knut, 12489 Berlin (DE); Raith, Andreas, 94267 Prackenbach (DE); Dueben, Reimo, 15566 Schöneiche (DE); Wurzer, Christian, 94244 Geiersthal (DE)
(74) Representative: Rupp, Christian

(57) **Abstract**

Disclosed is an *N*-way radio frequency, RF, splitter-combiner, comprising an inner conductor (6) including a plurality of (*N*) stepped cross-section conductor branches (1) extending radially and evenly circumferentially spaced in a reference plane *R* from a hub end (3); and a stepped cross-section conductor trunk (2) extending perpendicularly to the reference plane *R* from the hub end (3). This avoids power imbalance and excessive attenuation.

## Description

### Technical Field

The present disclosure relates generally to the field of radio frequency (RF) engineering, and in particular to an N-way RF splitter-combiner as well as to an arrangement comprising the same.

### Background Art

Wilkinson RF couplers use quarter wave transformation to achieve isolation between output ports and matching on all ports.

Being made up of passive components only, such RF couplers are reciprocal and may thus serve as splitters as well as combiners.

Typically, isolation resistors between the output ports serve to suppress power imbalances due to nonidealities. However, significant power imbalance may also arise in planar Wilkinson designs having more than two port counts due to electrical nonsymmetrical layout, for example, which may hence suffer from excessive attenuation.

Printed Wilkinson designs cannot transfer high RF power generally.

### Summary

It is an object to overcome the above-mentioned and other drawbacks.

The foregoing and other objects are achieved by the features of the independent claims. Further implementation forms are apparent from the dependent claims, the description and the figures.

According to a first aspect, an *N*-way radio frequency, RF, splitter-combiner is provided, comprising an inner conductor, comprising a plurality of conductor branches with varying (i.e. continuously varying or with stepped) cross-section, extending radially and evenly circumferentially spaced in a reference plane from a hub end; and conductor trunk with varying (i.e. continuously varying or with stepped) cross-section, extending perpendicularly to the reference plane from the hub end.

The cross-section variation thereby is such that the contour tapers from one end to the other end.

As used herein, *N*-way may refer to *N* (partial power) branches and a single (total power) trunk.

As used herein, a hub end may refer to a common end or star point.

As used herein, a trunk may refer to a conductor having a solid cross-section with no voids.

As used herein, stepped cross-section may refer to a step-wise change of a conductor's cross-section (and thus impedance) along the conductor.

The conductor trunk and the plurality of conductor branches may be fastened at the hub end. Any kind of fastening can be used such as e,g. welding, screw fastening, soldering, or be made from one piece only e.g. using 3d printing or milling.

The conductor trunk may be turned from a metal rod as one piece; and/or the conductor trunk may be silver plated; and/or the conductor trunk may be polished.

The plurality of conductor branches may have a circular cross-section.

The plurality of conductor branches may have a rectangular cross-section.

The plurality of conductor branches may be cut or punched from a sheet metal as one piece; and/or the plurality of conductor branches may be silver plated; and/or the plurality of conductor branches may be polished.

One or more of the plurality of conductor branches may extend radially in a straight manner; and/or one or more of the plurality of conductor branches may extend radially in a bent or inflected manner.

The RF splitter-combiner may further comprise an outer conductor, comprising a trace-receiving metal plate extending parallel to the reference plane; a trace-covering metal plate extending parallel to the reference plane; and a trunk-receiving metal piece extending perpendicular to the reference plane.

The trace-receiving metal plate may comprise a base plate of a heat sink; and/or the trace-receiving metal plate may have a plurality of recess channels corresponding to the plurality of conductor branches; and/or the plurality of recess channels may have stepped cross-sections; and/or the plurality of recess channels may be milled from the trace-receiving metal plate; and/or the trace-receiving metal plate may have a penetration hole in alignment with an extension direction of the conductor trunk; and/or the trace-covering metal plate may have penetration holes corresponding to radial ends of the plurality of conductor branches; and/or the trace-covering metal plate may have a blind recess configured to accommodate a surface-mounted circuit element of a flip-mountable circuit board; and/or the blind recess may be milled from the trace-covering metal plate; and/or the trunk-receiving metal piece may have a penetration hole in alignment with an extension direction of the conductor trunk; and/or the trunk-receiving metal piece may have a service opening in alignment with the extension direction of the conductor trunk, the service opening being configured to accommodate a tuning element; and/or the penetration hole of the trunk-receiving metal piece may have a stepped cross-section.

Thus, the penetration hole may present a straight (constant) cross-section, but alternatively it may present over a part or its entire extension a stepped cross-section matching the stepped cross-section of the conductor trunk 2. Thus, one or both of the inner wall of the penetration hole and the conductor trunk 2 may present a stepped cross-section.

The RF splitter-combiner may further comprise a plurality of retaining support elements, configured to mutually space and isolate the inner conductor and the outer conductor from one another.

The plurality of retaining support elements may be made from one of: Polytetrafluoroethylene, PTFE, and Polyether ether ketone, PEEK, Fluoroloy.

The plurality of conductor branches may comprise respective input terminals at respective radial ends, the respective input terminal comprising a connection means of: a soldering pad, and a plug connector.

The RF splitter-combiner may further comprise an output connector; and one or more of: a connecting piece between a radial end of the conductor trunk and the output connector; and an interchangeable RF filter between the radial end of the conductor trunk and the output connector.

According to a second aspect, an arrangement is provided, comprising an RF splitter-combiner of the first aspect; and a circuit board, configured for flip-mounting on the RF splitter-combiner.

The RF splitter-combiner and the circuit board may have mutually corresponding connection means.

### Brief Description of Drawings

The above-described aspects and implementations will now be explained with reference to the accompanying drawings, in which the same or similar reference numerals designate the same or similar elements.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a perspective view of an inner conductor of an *N*-way RF splitter-combiner in accordance with the present disclosure;
- FIGs. 2-5: illustrate top views of various conductor branches of the *N*-way RF splitter-combiner in accordance with the present disclosure;
- FIG. 6: illustrates a top view of the conductor branches of FIG. 5 inserted in a trace-receiving metal plate 10, in accordance with the present disclosure;
- FIG. 7: illustrates a cross-section view of the *N-*way RF splitter-combiner in accordance with the present disclosure;
- FIGs. 8 - 9: illustrate cross-section views of the radial ends of the *N*-way RF splitter-combiner in accordance with the present disclosure; and
- FIG. 10: illustrates top and cross-section views of an arrangement of an RF splitter-combiner and multiple circuit boards in accordance with the present disclosure.

### Detailed Descriptions of Drawings

In the following description, reference is made to the accompanying drawings, which form part of the disclosure, and which show, by way of illustration, specific aspects of implementations of the present disclosure or specific aspects in which implementations of the present disclosure may be used. It is understood that implementations of the present disclosure may be used in other aspects and comprise structural or logical changes not depicted in the figures. The following detailed description, therefore, is not to be taken in a limiting sense, and the scope of the present disclosure is defined by the appended claims.

For instance, it is understood that a disclosure in connection with a described method may also hold true for a corresponding apparatus or system configured to perform the method and vice versa. For example, if one or a plurality of specific method steps are described, a corresponding device may include one or a plurality of units, e.g. functional units, to perform the described one or plurality of method steps (e.g. one unit performing the one or plurality of steps, or a plurality of units each performing one or more of the plurality of steps), even if such one or more units are not explicitly described or illustrated in the figures. On the other hand, for example, if a specific apparatus is described based on one or a plurality of units, e.g. functional units, a corresponding method may include one step to perform the functionality of the one or plurality of units (e.g. one step performing the functionality of the one or plurality of units, or a plurality of steps each performing the functionality of one or more of the plurality of units), even if such one or plurality of steps are not explicitly described or illustrated in the figures. Further, it is understood that the features of the various exemplary implementations and/or aspects described herein may be combined with each other, unless specifically noted otherwise.

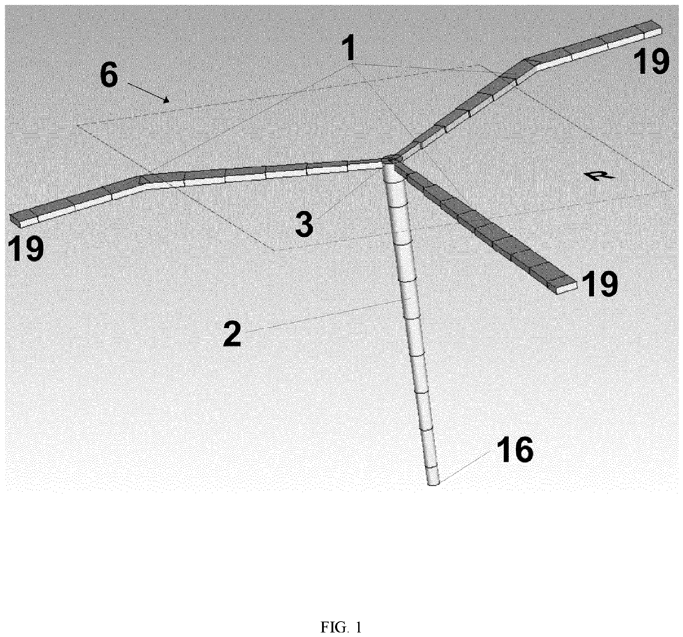

FIG. 1 illustrates a perspective view of an inner conductor 6 of an *N*-way RF splitter-combiner in accordance with the present disclosure.

The inner conductor *6* includes a plurality of *N* conductor branches *1* extending radially within a reference plane *R* from a common or hub end *3.*

The cross-sections of the conductor branches may vary continuously or in a stepped manner. The cross-section variation thereby is such that the contour tapers from one end to the other end.

The conductor branches *1* are evenly spaced in a circumferential direction and may comprise respective input terminals *19* at respective radial ends.

Generally, the plurality of conductor branches *1* may have similar cross-sections, for example a circular cross-section.

In the example of FIG. 1, the conductor branches *1* have rectangular cross-sections. Accordingly, the conductor branches *1* may be cut or punched from a sheet metal as one piece. The conductor branches *1* may be silver plated and/or polished for minimum attenuation.

In the example of FIG. 1, the stepped cross-section increases from the hub end 3 towards the respective radial ends, thereby transforming an impedance of the respective conductor branch *1* and achieving wideband matching.

Generally, one or more of the plurality of conductor branches *1* may extend radially in a straight manner, and/or one or more of the plurality of conductor branches *1* may extend radially in a bent or inflected manner, so as to optimize a positional arrangement of the respective input terminal *19* at respective radial end.

If the conductor branches *1* are bent or inflected similarly (e.g. same inflection angle, same construction), a direction of the inflection is electrically irrelevant, such that a power balance between the conductor branches *1* remains unaffected. Marginal departures from strict symmetry may result in acceptable summation errors.

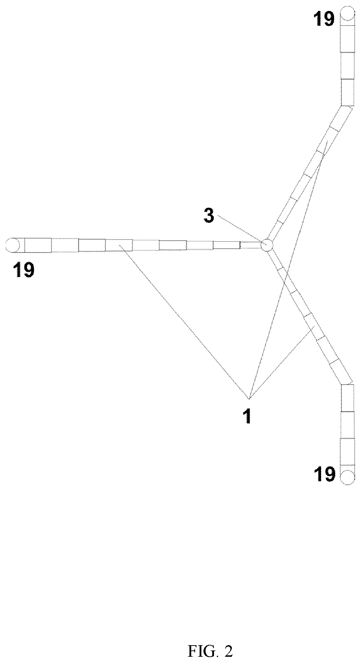

The example of FIGs. 1 - 2 comprises one straight conductor branch *1* and two inflected conductor branches *1.*

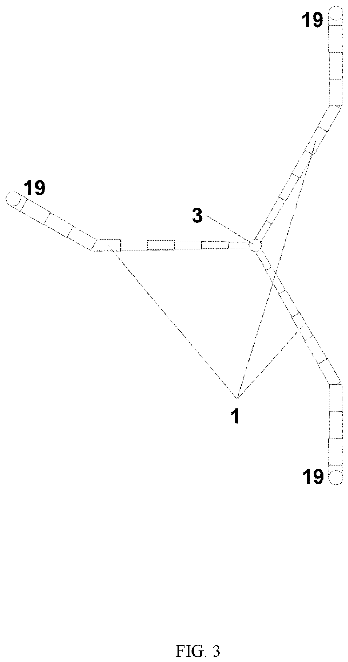

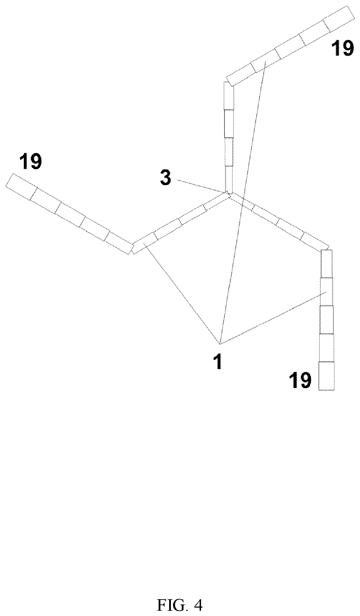

The examples of FIGs. 3 - 4 comprise three inflected conductor branches *1.*

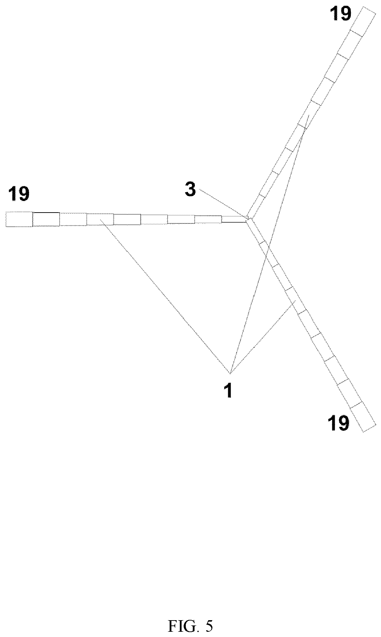

The example of FIG. 5 comprises three straight conductor branches *1.*

Returning to FIG. 1, the inner conductor *6* further includes a stepped cross-section conductor trunk 2 extending perpendicularly to the reference plane *R* from the hub end 3.

The conductor trunk *2* may be turned from a metal rod as one piece; and/or the conductor trunk *2* may be silver plated; and/or the conductor trunk *2* may be polished.

In particular, the conductor trunk *2* and the plurality of conductor branches *1* may be screw fastened at the hub end *3.*

The RF splitter-combiner may further comprise an outer conductor *9* which is explained next.

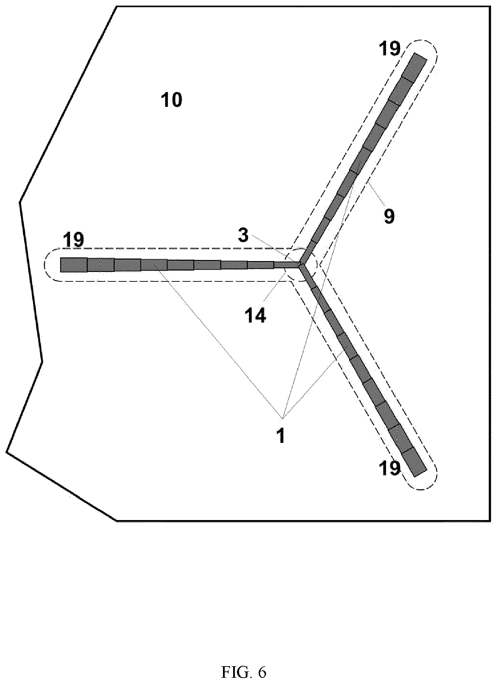

FIG. 6 illustrates a top view of the conductor branches 1 of FIG. 5 inserted in a trace-receiving metal plate 10, in accordance with the present disclosure.

The trace-receiving metal plate *10* may have a plurality of *N* recess channels corresponding to the plurality of conductor branches *1* and may form part of an outer conductor *9* of the RF splitter-combiner and extends parallel to the reference plane *R.*

In the example of FIG. 6, the recess channels have straight cross-sections, but they may have stepped cross-sections as well, corresponding to the stepped cross-section of the conductor branches *1.*

In particular, the plurality of recess channels may be milled from the trace-receiving metal plate *10,* which may particularly comprise a base plate of a heat sink.

The trace-receiving metal plate *10* may further comprise a penetration hole (at the hub end 3) in alignment with an extension direction of the conductor trunk 2.

The outer conductor *9* may further comprise a trunk-receiving metal piece *15* extending perpendicular to the reference plane *R,* which is explained next.

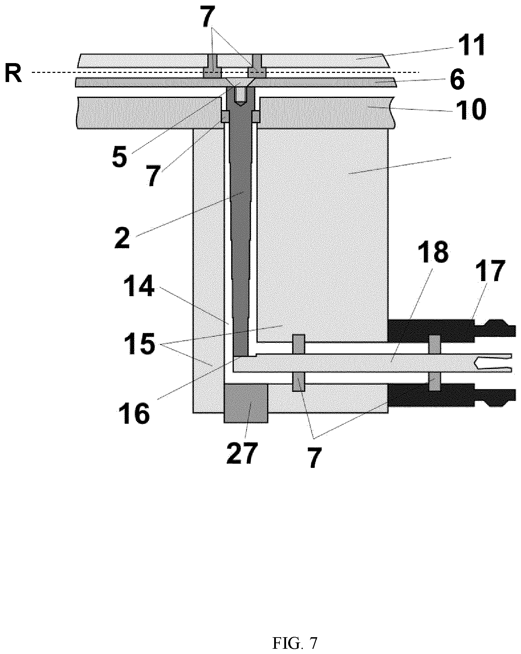

FIG. 7 illustrates a cross-section view of the *N*-way RF splitter-combiner in accordance with the present disclosure.

The trunk-receiving metal piece *15* may be dimensioned such that the cross section of metal piece 15 is obstructing flow of air in a direction of the cooling fins in the smallest possible way.

The trunk-receiving metal piece *15* may have a penetration hole in alignment with an extension direction of the conductor trunk *2,* thereby forming a coaxial transmission line with the same. An air in the gap *14* serves as a dielectric., but any other suitable material e.g. Teflon, PEEK, according to its permittivity.

In the example of FIG. 7, the penetration hole has a straight (constant) cross-section, but alternatively it may present over a part or its entire extension a stepped cross-section matching the stepped cross-section of the conductor trunk 2. Thus, one or both of the inner wall of the penetration hole and the conductor trunk 2 may present a stepped cross-section.

Additionally, the trunk-receiving metal piece *15* may have a service opening in alignment with the extension direction of the conductor trunk *2.* Said service opening may be configured to accommodate a tuning element *27.*

The RF splitter-combiner may further comprise a plurality of retaining support elements *7* configured to mutually space and isolate the inner conductor *6* and the outer conductor *9* from one another.

In particular, the plurality of retaining support elements *7, 24, 26* may be made from one of: Polytetrafluoroethylene, PTFE, and Polyether ether ketone, PEEK, Fluoroloy thereby maximizing electric isolation and minimizing attenuation.

The RF splitter-combiner may further comprise an output connector *17,* especially a standard coaxial plug connector for up to 20 GHz, and smaller connectors or a hollow conductor / waveguide beyond 20 GHz. At such high frequencies, hollow conductors / waveguides enable a higher power transfer at the expense of bandwidth.

In FIG. 7, a connecting piece *18* is interposed between a radial end *16* of the conductor trunk *2* and the output connector *17.* The connecting piece *18* may be configured to achieve a part of the required impedance transformation between the hub end 3 and the output connector *17* (i.e., extending the conductor trunk **2**). Alternatively, the connecting piece *18* may comprise a harmonics filter. Alternatively, the connecting piece *18* may form part of a directional coupler or a lightening protection or a customer specific RF filter. Alternatively, an interchangeable, customer-specific RF filter may also be arranged between the radial end *16* of the conductor trunk *2* and the output connector *17.*

The outer conductor *9* may further comprise a trace-covering metal plate *11* extending parallel to the reference plane *R,* which is explained next.

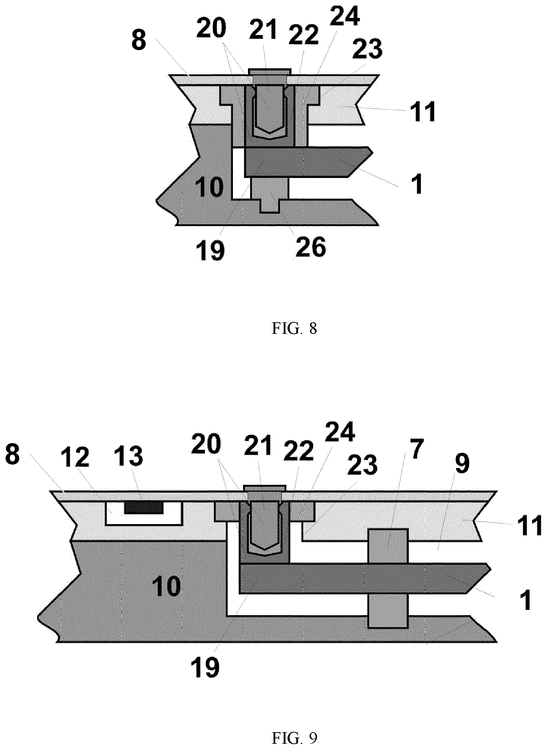

FIGs. 8 - 9 illustrate cross-section views of the radial ends of the *N*-way RF splitter-combiner in accordance with the present disclosure.

As previously mentioned, the conductor branches *1* may comprise respective input terminals *19* at respective radial ends.

The trace-covering metal plate *11* may have penetration holes 23 corresponding to the radial ends of the plurality of conductor branches *1.*

The respective input terminal *19* may especially comprise a connection means of: a soldering pad, and a plug (female / male) connector *20,* configured to mate with a corresponding plug (male / female) connector *21* of the afore-mentioned flip-mountable circuit board 8. For example, the plug (female / male) connector *20* may protrude perpendicularly to the reference plane R, and the corresponding plug (male / female) connector *21* may as well protrude perpendicularly to the reference plane Rand be subject to automatic assembly / mounting based on (reflow) soldering in a via.

The circuit board 8 may particularly comprise an amplifier element / circuit (MIC).

Said plug connection *20, 21* minimizes a signal path / attenuation, enables an arbitrary orientation of the flip-mounted circuit board 8 relative to the respective conductor branch *1,* and further enables an arbitrary choice of impedance level for signal handover to the RF splitter-combiner.

The RF splitter-combiner may further comprise a plurality of retaining support elements *7, 24, 26,* configured to mutually space and isolate the inner conductor *6, 1* and the outer conductor *9*, *10, 11* from one another, thereby forming a stripline transmission line with the same.

The retaining support elements *24* may comprise isolation spacers corresponding to stepped cross-section penetration holes *23* of the trace-covering metal plate *11*, so that the isolation spacers cannot be forced through said plate 11. The retaining support elements *24* may further be configured to define a spacing between said plate 11 and the respective conducting branch 1.

The trace-covering metal plate *11* may further have a blind recess *12* configured to accommodate a surface-mounted circuit element *13* of a flip-mountable circuit board *8,* thereby enabling deployment of double-sided circuit boards *8* and shielding the circuit element *13* with respect to the RF splitter-combiner or other elements of the circuit board *8.* In particular, the blind recess *12* may be milled from the trace-covering metal plate *11*.

Alternatively, the trace-covering metal plate *11* may be formed by a ground plane on a flat side of a single-sided circuit board *8.*

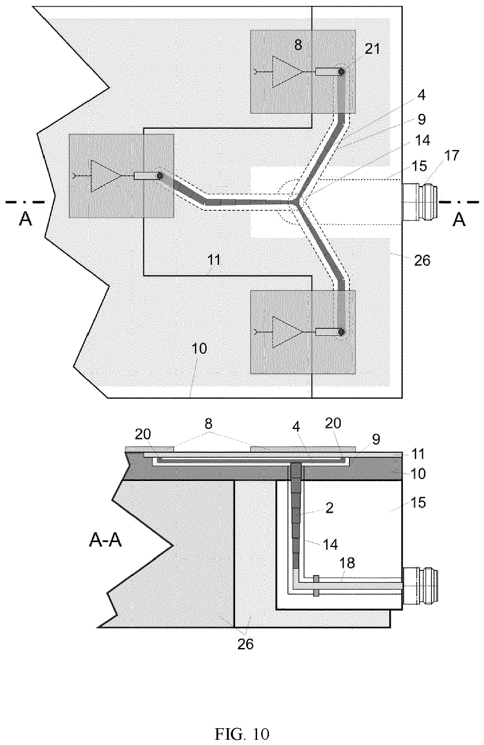

FIG. 10 illustrates top and cross-section views of an arrangement of an RF splitter-combiner and multiple circuit boards 8 in accordance with the present disclosure.

In particular, the RF splitter-combiner and the circuit boards *8* may have mutually corresponding connection means *20, 21,* such as plug (male / female) connectors, as previously mentioned.

Note the arbitrary orientation of the flip-mounted circuit boards *8* relative to the respective conductor branch *1,* such as perpendicularly to cooling fins of a heat sink, so as to distribute the circuit boards *8* across the heat sink.

Preferably, the circuit boards *8* are fixed / screwed in this orientation so as to avoid shear forces acting on the connection means *20, 21.*

Note that the proposed RF splitter-combiner lacks the isolation resistors that are typical for Wilkinson couplers, and therefore avoids excessive attenuation.

The RF splitter-combiner has predominantly been described as a combiner. A deployment as a splitter is only meaningful for very high powers.

The RF splitter-combiner is especially useful for *N>2* as for *N*=*2* there may be planar solutions with theoretically ideal power summation.

The present disclosure has been described in conjunction with various implementations as examples. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation. A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. An *N*-way radio frequency, RF, splitter-combiner, comprising
an inner conductor (6), comprising
a plurality of (*N*) conductor branches (1) with varying, e.g, stepped cross-section, extending radially and evenly circumferentially spaced in a reference plane (R) from a hub end (3); and
a stepped cross-section conductor trunk (2), extending perpendicularly to the reference plane (R) from the hub end (3).

2. The RF splitter-combiner of claim 1,
the conductor trunk (2) and the plurality of conductor branches (1) being fastened at the hub end (3).

3. The RF splitter-combiner of claim 1 or claim 2,
the conductor trunk (2) being turned from a metal rod as one piece; and/or
the conductor trunk (2) being silver plated; and/or
the conductor trunk (2) being polished.

4. The RF splitter-combiner of any one of the claims 1 to 3,
the plurality of conductor branches (1) having a circular cross-section, a rectangular cross-section or a mix thereof.

5. The RF splitter-combiner of claim 4,
the plurality of conductor branches (1) being cut or punched from a sheet metal as one piece; and/or
the plurality of conductor branches (1) being silver plated; and/or
the plurality of conductor branches (1) being polished.

6. The RF splitter-combiner of any one of the preceding claims,
one or more of the plurality of conductor branches (1) extending radially in a straight manner; and/or
one or more of the plurality of conductor branches (1) extending radially in a bent or inflected manner.

7. The RF splitter-combiner of any one of the preceding claims, further comprising
- an outer conductor (9), comprising
- a trace-receiving metal plate (10) extending parallel to the reference plane (R);
- a trace-covering metal plate (11) extending parallel to the reference plane (R); and
- a trunk-receiving metal piece (15) extending perpendicular to the reference plane (R).

8. The RF splitter-combiner of claim 7,
the trace-receiving metal plate (10) comprising a base plate of a heat sink; and/or
the trace-receiving metal plate (10) having a plurality of (*N*) recess channels corresponding to the plurality of conductor branches (1); and/or
the plurality of recess channels having stepped cross-sections; and/or
the plurality of recess channels being milled from the trace-receiving metal plate (10); and/or
the trace-receiving metal plate (10) having a penetration hole in alignment with an extension direction of the conductor trunk (2); and/or
the trace-covering metal plate (11) having penetration holes (23) corresponding to radial ends of the plurality of conductor branches (1); and/or
the trace-covering metal plate (11) having a blind recess (12) configured to accommodate a surface-mounted circuit element (13) of a flip-mountable circuit board (8); and/or
the blind recess (12) being milled from the trace-covering metal plate (11); and/or
the trunk-receiving metal piece (15) having a penetration hole in alignment with an extension direction of the conductor trunk (2); and/or
the trunk-receiving metal piece (15) having a service opening in alignment with the extension direction of the conductor trunk (2), the service opening being configured to accommodate a tuning element (27); and/or
the penetration hole of the trunk-receiving metal piece (15) having a stepped cross-section.

9. The RF splitter-combiner of claim 7 or claim 8, further comprising
- a plurality of retaining support elements (7, 24, 26), configured to mutually space and isolate the inner conductor (6) and the outer conductor (9) from one another.

10. The RF splitter-combiner of claim 9,
the plurality of retaining support elements (7, 24, 26) being made from one of:
- Polytetrafluoroethylene, PTFE, and
- Polyether ether ketone, PEEK, Fluroroloy.

11. The RF splitter-combiner of any one of the preceding claims,
the plurality of conductor branches (1) comprising respective input terminals (19) at respective radial ends, the respective input terminal (19) comprising a connection means of:
- a soldering pad, and
- a plug connector (20) or a contact element such as e.g. a pin, fitted into an opening.

12. The RF splitter-combiner of any one of the preceding claims, further comprising
- an output connector (17); and one or more of:
- a connecting piece (18) between a radial end (16) of the conductor trunk (2) and the output connector (17); and
- an interchangeable RF filter between the radial end (16) of the conductor trunk (2) and the output connector (17).

13. An arrangement, comprising
- an RF splitter-combiner of any one of the preceding claims; and
- a circuit board (8), configured for flip-mounting on the RF splitter-combiner.

14. The arrangement of claim 13,
the RF splitter-combiner and the circuit board (8) having mutually corresponding connection means (20, 21).
